# EUROPEAN PATENT SPECIFICATION

(11) **EP 1 608 032 B1**
(45) Date of publication and mention of the grant of the patent: **23.11.2011**
(21) Application number: 05012738.0
(22) Date of filing: 14.06.2005
(51) Int. Cl.: H01L 51/52, H01L 27/32

(54) **Organic electro-luminescence display device and fabricating method thereof**
Organische elektrolumineszente Anzeigevorrichtung und Herstellungsverfahren
Dispositif d'affichage électroluminescent organique et méthode de fabrication

(30) Priority: 16.06.2004 KR 2004044331
(43) Date of publication of application: 21.12.2005
(73) Proprietor: LG Electronics, Inc., Seoul (KR)
(72) Inventor: Park, Chong Hyun, Daegu (KR)
(74) Representative: Zech, Stefan Markus

(56) References cited:
- WO-A2-03/096440
- US-A1- 2002 000 560
- US-B1- 6 590 337
- US-B1- 6 624 572

## Description

### BACKGROUND OF THE INVENTION

### FIELD OF THE INVENTION

This invention relates to an electro-luminescence display (ELD), and more particularly, to an organic electroluminescence display device and a fabricating method thereof that are adaptive for improving an adhesion of a sealant used in an encapsulation process.

### Description of the Related Art

WO 03/096 440 A2 discloses a method to ensure uniform deposition of organic layer. By covering the metal interconnects, the uniformity of the polymer layer shall be enhanced. A protection layer enables the removal of polymer materials used to form the OLED cells from the cap bonding region without damaging the layers below it. The removal of the organic layer improves the sealing. US 6 624 572 B1 discloses an organic electroluminescence display panel and method for sealing the same by forming a buffer layer of an organic matter and locating a shield cover on the buffer layer. US 2002/000 560 A1 and US 6 590 337 B1 disclose the formation of an insulating pattern on the signal lines in the seal line area to improve the sealing of an OLED display.

Recently, there have been developed various flat panel display devices reduced in weight and bulk that are capable of eliminating disadvantages of a cathode ray tube (CRT). Such flat panel display devices include a liquid crystal display (LCD), a field emission display (FED), a plasma display panel (PDP) and an electro-luminescence (EL) display, etc. device. In such flat panel display devices, the PDP has the most advantage for making a large dimension screen because its structure and manufacturing process are simple, but has a drawback in that it has low light-emission efficiency and large power consumption. The LCD has a difficulty in making a large dimension screen because it is fabricated by a semiconductor process, but has an expanded demand as it is mainly used for a display device of a notebook personal computer. However, the LCD has a drawback in that it has a difficulty in making a large dimension screen and it has large power consumption due to a backlight unit. Also, the LCD has characteristics of a large light loss and a narrow viewing angle due to optical devices such as a polarizing filter, a prism sheet, a diffuser and the like. On the other hand, the EL display device is largely classified into an inorganic EL device and an organic EL device depending upon a material of a light-emitting layer, and is a self-luminous device. When compared with the above-mentioned display devices, the EL display device has advantages of a fast response speed, large light-emission efficiency, a large brightness and a large viewing angle. The organic EL display device can display a picture at approximately 10V and a high brightness of ten thousands of cd/m². The organic EL display device is largely used for a mini type display such as mobile phone and the like.

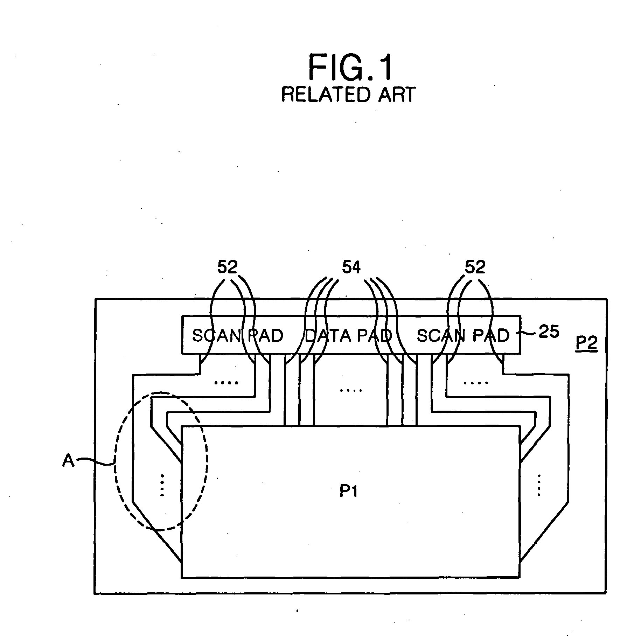

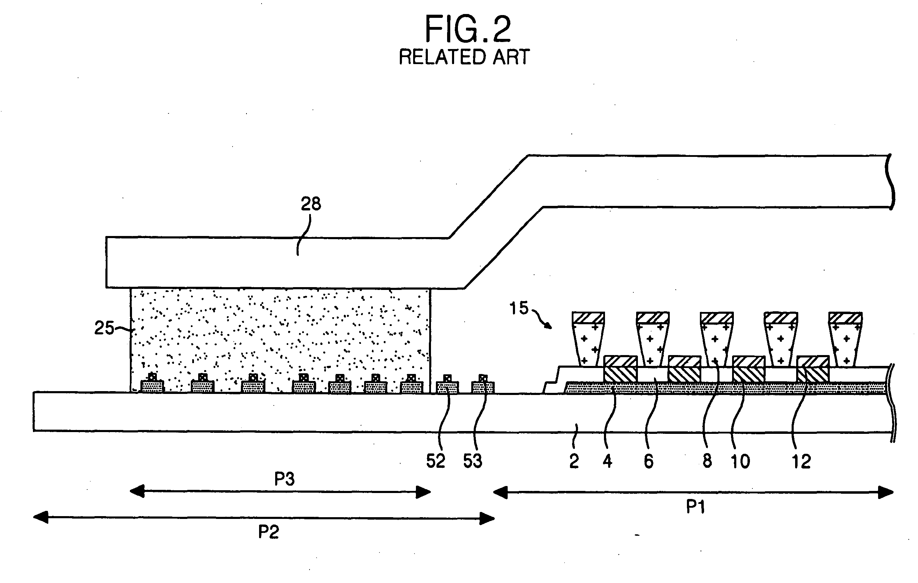

FIG. 1 is a schematic view showing a related art organic EL display device, and FIG. 2 is a sectional view specifically illustrating 'A' area in FIG. 1.

Referring to FIG. 1 and FIG. 2, the related art EL display device includes: a display area P1 provided with an organic EL array; and a non-display area P2 provided with a pad portion 25 for applying driving signals to driving electrodes at the display area P1 and a adhering area P3(or seal line area) both of a cap 28 and a substrate 2.

The display area P1 is provided with an anode electrode 4 formed on the substrate 2, and a cathode electrode 12 formed in a direction crossing the anode electrode 4.

A plurality of anode electrodes 4 are provided on the substrate 2 in such a manner to be spaced at a desired distance from each other. The anode electrode 4 is partially exposed, to thereby form an insulating film 6 defining a light-emitting area on the substrate 2 having the anode electrode 4. On the insulating film 6, a barrier rib 8 for making a separation of an organic light-emitting layer 10 and the cathode electrode 12 to be formed thereon is provided. The barrier rib 8 is formed in a direction crossing the anode electrode 4, and has an overhang structure in which the upper portion thereof has a larger width than the lower portion thereof. The organic light-emitting layer 10 made of an organic compound and the cathode electrode 12 are entirely deposited onto the insulating film 6 provided with the barrier rib 8. The organic light-emitting layer 10 is formed by depositing a hole injection layer, a hole carrier layer, a light-emitting layer, an electron carrier layer and an electron injection layer onto the anode electrode 4.

The non-display area P2 is provided with a first line 54 extended from the anode electrode 4 at the display area P1, data pads for supplying data voltages, via the first line 54, to the anode electrode 4, a second line 52 connected to the cathode electrode 12, and scan pads for supplying scan voltages via the second line 52. Herein, the first and the second lines 54 and 52 are formed of the same transparent electrode material as the anode electrode 4, and a conductive metal layer 53 is further formed of molybdenum and the like, on the second line 52 in order to reinforce a conductivity of the second line 52.

The data pad is connected to a tape carrier package (TCP) mounted with a first driving circuit for generating data voltages to thereby supply the data voltage to each anode electrode 4. The scan pad is provided at each side of the data pad. The scan pad is connected to a TCP mounted with a second driving circuit for generating scan voltages, to thereby supply the scan voltage to each cathode electrode 12.

The cap 28, adhered to the substrate 2 via the sealant 25 at the seal line area P3 of the non-display area P2, prevents the organic EL array 15 of the display area P1 from oxygen and moisture in the area.

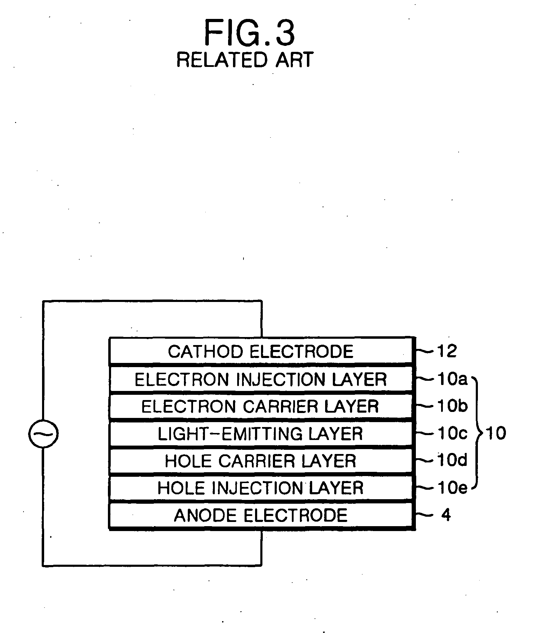

As shown in FIG. 3, in the related art organic EL display device having the structure as mentioned above, if a voltage is applied between the anode electrode 4 and the cathode electrode 12, then electrons (or cathodes) generated from the cathode electrode 12 are moved, via an electron injection layer 10a and an electron carrier layer 10b, into a light-emitting layer 10c. On the other hand, holes (or anodes) generated from the anode electrode 4 are moved, via a hole injection layer 10e and a hole carrier layer 10d, into the light-emitting layer 10c.

Accordingly, in the light-emitting layer 10c, the electron and the hole supplied from the electron carrier layer 10b and the hole carrier layer 10d are recombined to form an exiton, and the exiton is excited again to a ground state, thus a light of a fixed energy is emitted to the outside through the anode electrode 4, so that a picture is displayed.

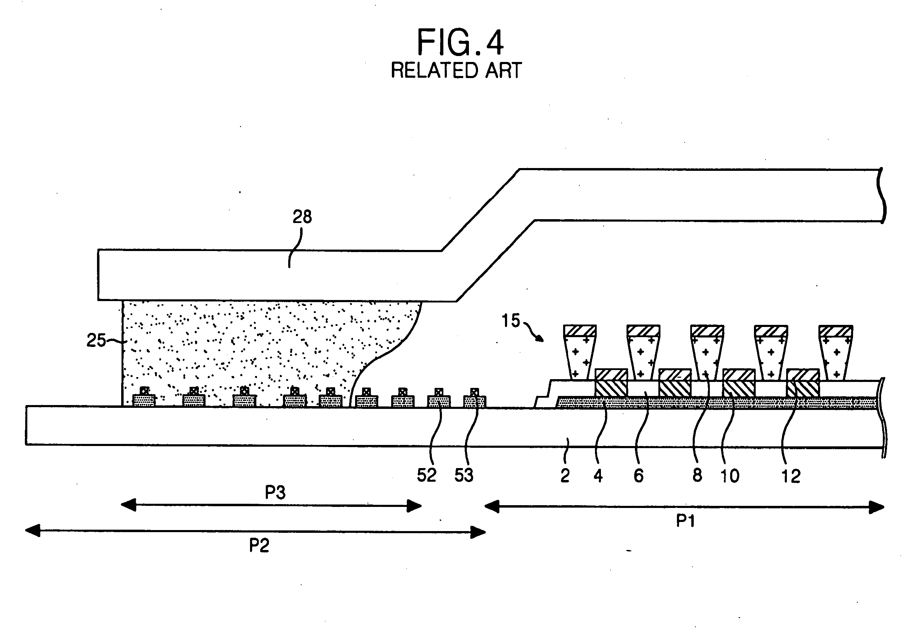

Meanwhile, in such an organic EL display device, the second line 52 turns around the display area P1 to connect to the scan pad, so that a plurality of second lines 52 are located at the seal line area P3 as shown in FIG. 4. The second lines 52 are densely arranged as it goes from the seal line area P3 to the display area P1. Accordingly, there is a problem that the sealant 25 is not uniformly at the seal line area P3 upon adhering the cap to the substrate 2, as shown in FIG. 4. In other words, since the densely arranged second lines 52 prevent that the sealant 25 is uniformly spread to the seal line area P3 upon adhering the can 28 to the substrate, a width of the spread sealant 25 becomes uneven.

Accordingly, in a case that an adhesive power both of the substrate 2 and the cap 28 becomes lowered and an unbalance pressure is generated at a fixed area, there is a problem of a packaging badness, i. e., the sealant 25 is partially broken.

### SUMMARY OF THE INVENTION

Accordingly, it is an object of the present invention to provide an organic electro-luminescence display device and a fabricating method thereof that are adaptive for improving an adhesion of a sealant used in an encapsulation process.

In order to achieve these and other objects of the invention, an organic electro-luminescence display device according to an embodiment of the present invention includes: a substrate provided with an organic electroluminescence array having first and second electrodes crossing each other with having an organic light-emitting layer therebetween; a cap adhered via a sealant to a seal line area; a plurality of signal lines connected to any one of the first and the second electrodes and located on the seal line area; the plurality of signal lines are arranged, within the seal line area, by a narrower distance as it goes from the seal line area to the organic electro-luminescence array; a dummy insulating pattern is overlapped with a portion of the seal line area adjacent to the organic electro-luminescence array, to cover only that portion of the signal lines more densely arranged on the seal line area.

The dummy insulating pattern is overlapped with the seal line area as much as more than 1/2 of the entire width of the seal line area.

The dummy insulating pattern is formed to cover more than 1/2 of the signal lines.

The organic electro-luminescence display device further includes an insulating film formed on the first electrode to define a light-emitting area, wherein the dummy insulating pattern is the same material as the insulating film.

A method of fabricating an organic electroluminescence display device according to an embodiment of the present invention includes: forming an organic electroluminescence array having first and second electrodes crossing each other with having an organic light-emitting layer therebetween; providing a cap adhered via a sealant to a seal line area; forming a plurality of signal lines connected to any one of the first and the second electrodes and located on the seal line area; forming the plurality of signal lines arranged, within the seal line area, by a narrower distance as it goes from the seal line area to the organic electroluminescence array; and forming a dummy insulating pattern which is overlapped with a portion of the seal line area adjacent to the organic electro-luminescence array, to cover only that portion of the signal lines more densely arranged on the seal line area.

The organic electro-luminescence array includes an insulating film defining the light-emitting area by partially exposing the first electrode, and the dummy insulating pattern is simultaneously formed of the same material as the insulating film.

### BRIEF DESCRIPTION OF THE DRAWINGS

These and other objects of the invention will be apparent from the following detailed description of the embodiments of the present invention with reference to the accompanying drawings, in which:

FIG. 1 is a schematic view showing a structure of a related art organic electro-luminescence display device;

FIG. 2 is a sectional view specifically illustrating ' A' area in FIG. 1;

FIG. 3 is a diagram for explaining a light-emitting principle of the organic electro-luminescence display device;

FIG. 4 is a sectional view for explaining a formation badness of the related art sealant;

FIG. 5 is a sectional view specifically illustrating a portion of the organic electro-luminescence display device according to the present invention; and

FIG. 6A to FIG. 6G are sectional views for sequentially explaining a method of fabricating the organic electro-luminescence display device shown in FIG. 5.

### DETAILED DESCRIPTION OF THE PREFERRED EMBODIMENT

Reference will now be made in detail to the preferred embodiments of the present invention, examples of which are illustrated in the accompanying drawings.

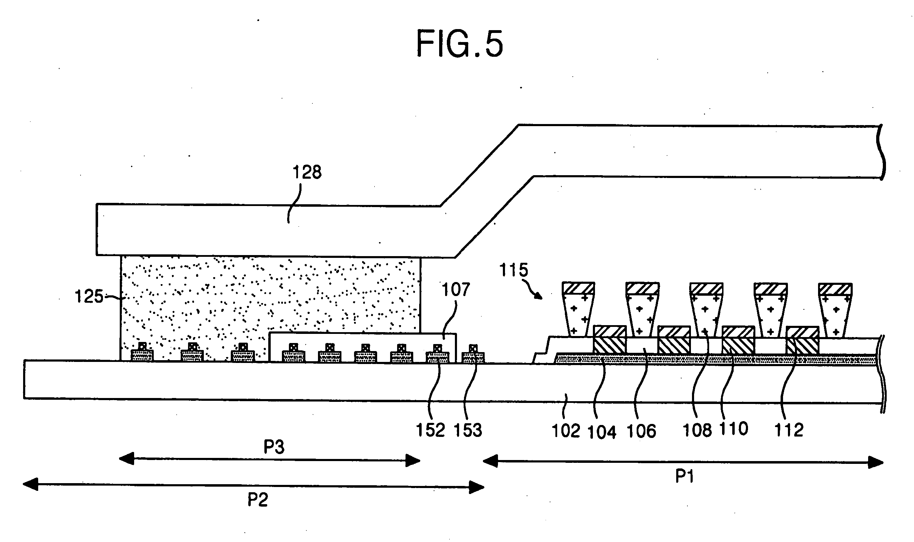

Hereinafter, the preferred embodiments of the present invention will be described in detail with reference to FIGs. 5 to 6G.

FIG. 5 is a schematic sectional view showing a portion of an organic electro-luminescence display device according to the present invention.

Referring to FIG. 5, the organic EL display device according to the present invention includes: a display area P1 provided with an organic EL array 115; and a non-display area P2 provided with a pad portion(not shown) for applying driving signals to driving electrodes at the display area P1 and an adhering area P3(or seal line area) both of a cap 128 and a substrate 102.

The display area P1 is provided with an anode electrode 104 formed on the substrate 102, and a cathode electrode 112 formed in a direction crossing the anode electrode 104.

A plurality of anode electrodes 104 are provided on the substrate 102 in such a manner to be spaced at a desired distance from each other. The anode electrode 104 is partially exposed, to thereby form an insulating film 106 defining a light-emitting area on the substrate 102 having the anode electrode 104. On the insulating film 106, a barrier rib 108 for making a separation of an organic light-emitting layer 110 and the cathode electrode 112 to be formed thereon is provided. The barrier rib 108 is formed in a direction crossing the anode electrode 104, and has an overhang structure in which the upper portion thereof has a larger width than the lower portion thereof. The organic light-emitting layer 110 made of an organic compound and the cathode electrode 112 are entirely deposited onto the insulating film 106 provided with the barrier rib 108. The organic light-emitting layer 110 is formed by depositing a hole injection layer, a hole carrier layer, a light-emitting layer, an electron carrier layer and an electron injection layer onto the anode electrode 104.

The non-display area P2 is provided with a first line(not shown) extended from the anode electrode 104 at the display area P1, data pads for supplying data voltages, via the first line, to the anode electrode 104, a second line 152 connected to the cathode electrode 112, and scan pads for supplying scan voltages via the second line 152. Herein, the first line and the second line 152 are formed of the same transparent electrode material as the anode electrode 104, and a conductive metal layer 153 is further formed of molybdenum and the like, on the second line 152 in order to reinforce a conductivity of the second line 152.

The cap 128, adhered to the substrate 102 via the sealant 125 at the seal line area P3 of the non-display area P2, prevents the organic EL array 115 of the display area P1 from oxygen and moisture in the area.

The organic EL display device according to the present invention further includes a dummy insulating pattern 107 at the seal line area P3 of the non-display area P2. The dummy insulating pattern 107 is formed to cover the second lines 152 densely located in the seal line area P3, so that the sealant 125 is corresponded to the seal line area P3 and is uniformly formed.

More specifically, this will be described as follows.

A portion of the second line 152, turning around the display area P1 to connect to the scan pad, is located at the seal line area P3, especially, becomes densely arranged as it goes from the seal line area P3 to the display area P1. Herein, the dummy insulating pattern 107 is formed to cover the densely arranged second line 152. And, the sealant 125 is located on the dummy insulating pattern 107, so that it is possible to prevent an uneven formation of the sealant caused by the second line 152 as compared with the related art. The dummy insulating pattern 107 might be formed to be overlapped with the seal line area P3 of a direction adjacent to the display area P1 and to be partially further enlarged from the seal line area P3 to the display area P1 direction. Furthermore, the dummy insulating pattern 107 might be formed to be overlapped with the seal line area P3 as much as more than a half thereof. Meanwhile, the dummy insulating pattern 107 is formed of an organic material identical to the insulating film 106 of the organic EL array 115 and a thickness of the dummy insulating pattern 107 is approximately 1.2µm, and a thickness of the second line 152 is approximately 0.1 µm (1000Å), so that the dummy insulating pattern 107 can reduce a stepped difference between the second line 152 and the substrate 102.

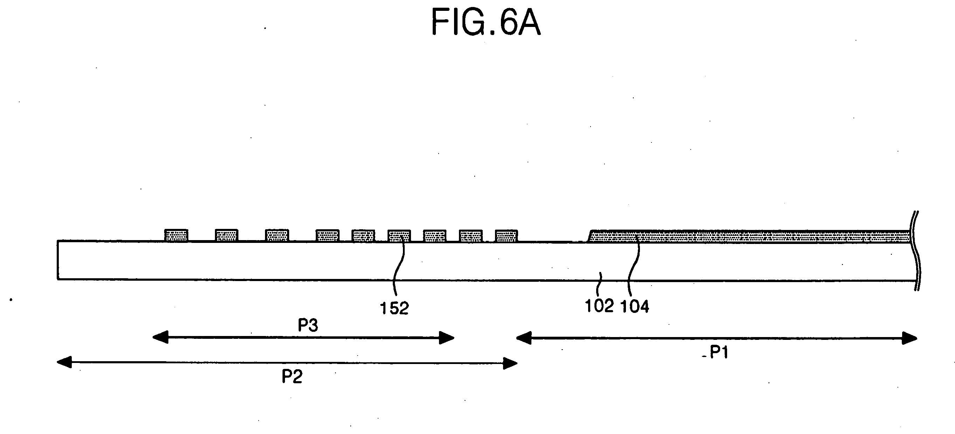

Hereinafter, a method of fabricating the organic EL display device will be described with reference to FIGs. 6A to 6G.

Firstly, as shown in FIG. 6A, the anode electrode 104 and the second line 152 are provided by depositing a transparent conductive metal material onto the substrate 102 made of a sodalime or a vulcanized glass and then patterning it by the photolithography and the etching process. Herein, indium-tin-oxide (ITO) or SnO₂ is used as the metal material.

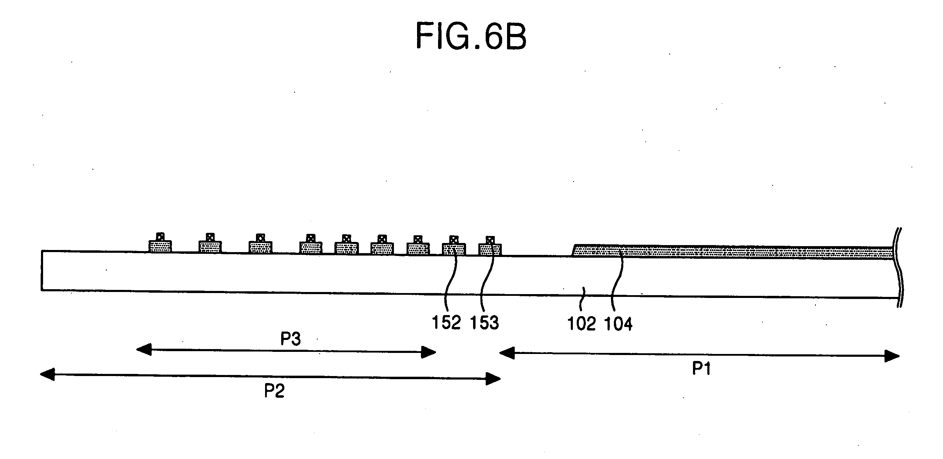

On the substrate 102, a conductive metal material such as molybdenum Mo and the like is deposited and is patterned by a photolithography process and an etching process, to thereby form the conductive metal layer 153 on the second line 152 as shown in FIG 6B.

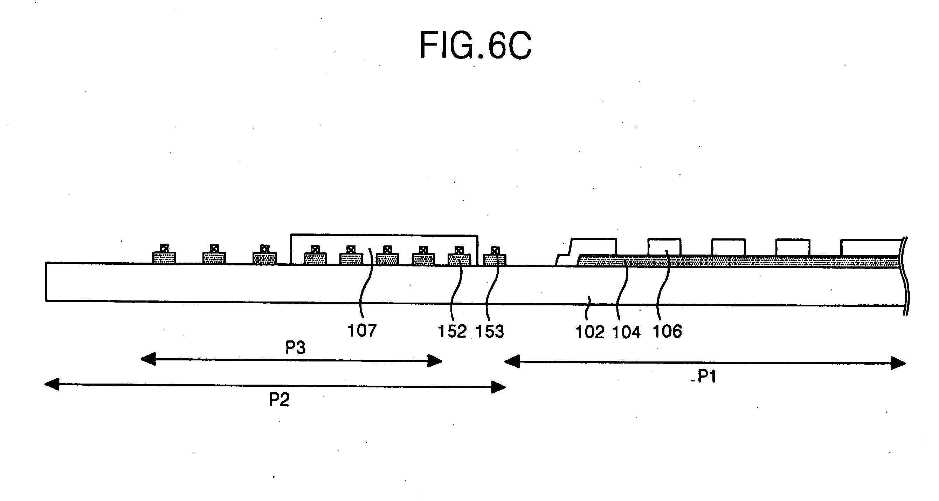

A photosensitive insulating material is coated on the substrate 102 having the anode electrode 104 and the second line 152 by a spin-coating method, and is patterned, to thereby form the insulating film 106 defining a light-emitting area of the display area P1 and the dummy insulating pattern 107 on the seal line area P3 as shown in FIG. 6C. Herein, the dummy insulating pattern 107 is formed to cover the second line 152 densely arranged on the seal line area P3, and might be formed to be partially further enlarged from the seal line area P3 to the display area P1 direction.

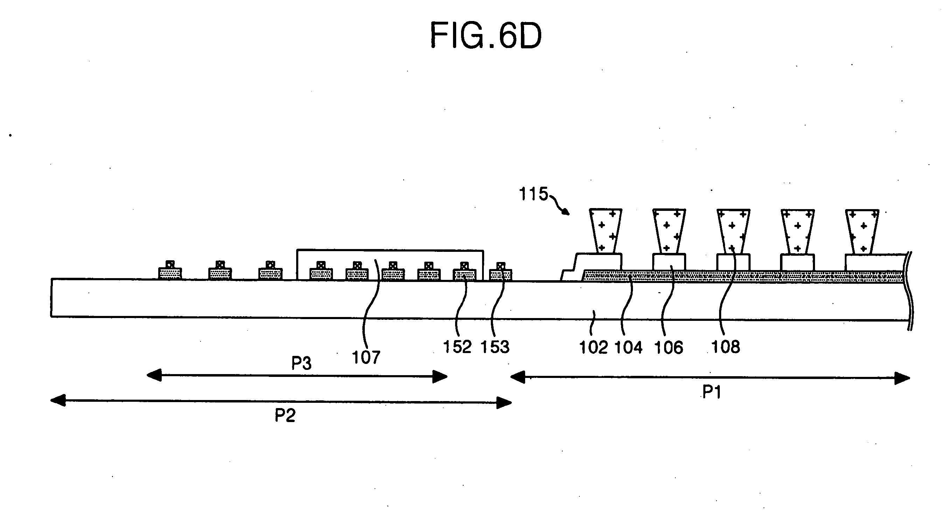

A photosensitive insulating material is deposited on the substrate 102 having the insulating film 106 and the dummy insulating pattern 107, and is patterned by a photolithography process and an etching process, to thereby form a barrier rib 108 as shown in FIG. 6D. The barrier rib 108 is formed at a non light-emitting area to be cross with the anode electrodes 104 in order to partition a pixel.

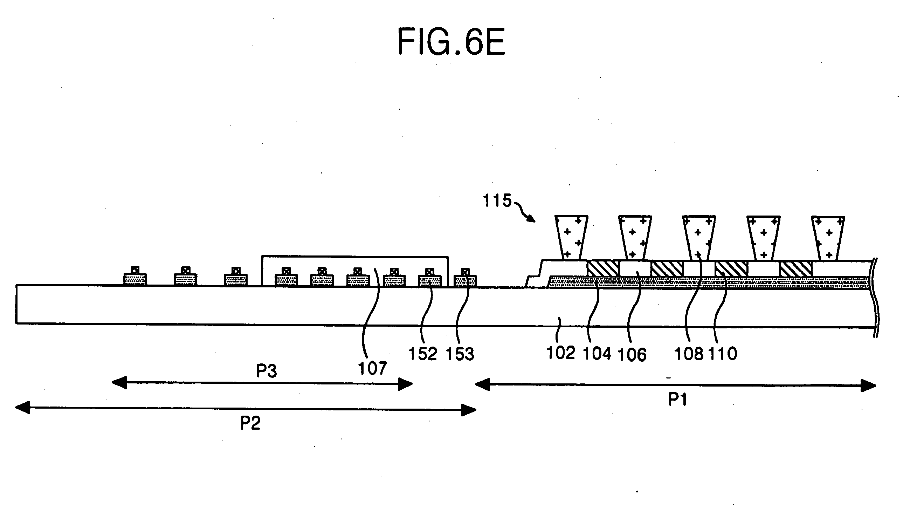

As shown in FIG. 6E, an organic light-emitting layer 110 is formed on the substrate 102 having the barrier rib 108 by a heat deposition, a vacuum deposition and the like using a common mask and a show mask, those are not shown.

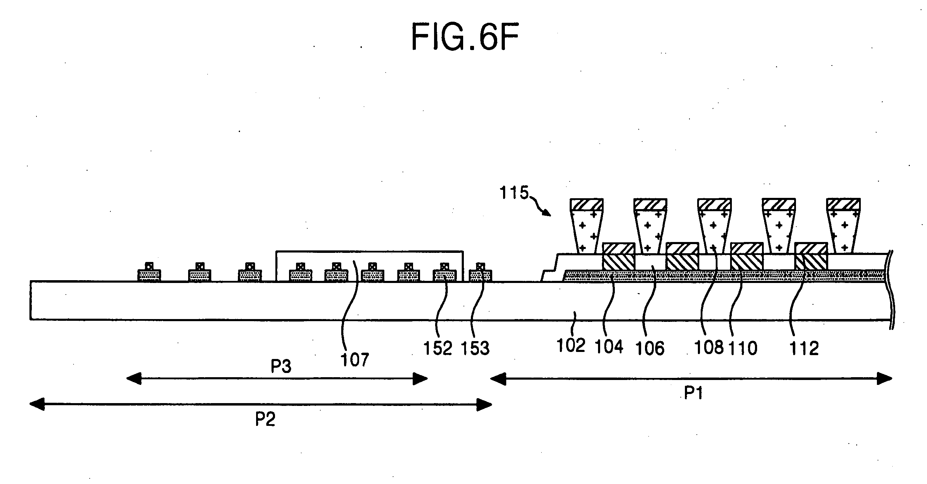

A metal material is deposited on the substrate 102 having the organic light-emitting layer 110, to thereby form a cathode electrode 112 as shown in FIG. 6F.

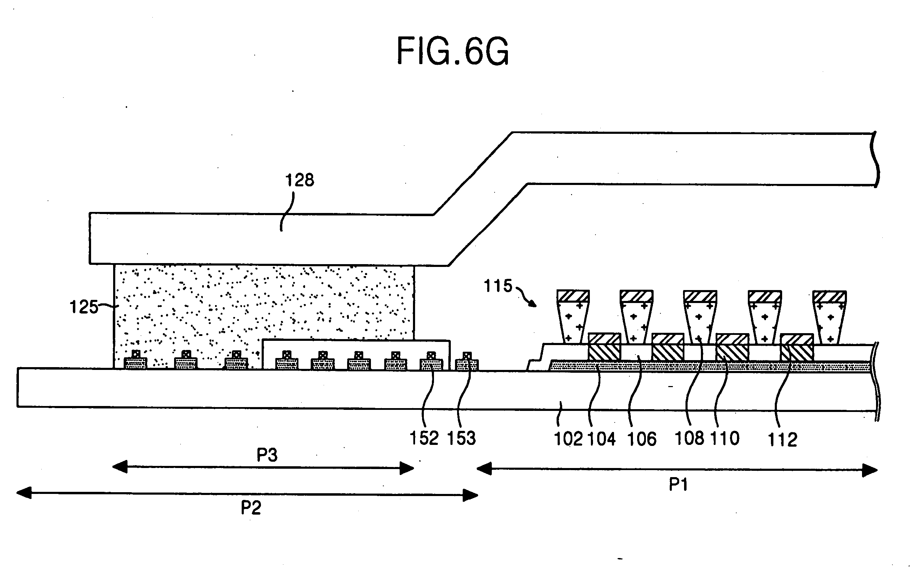

Thereafter, the sealant 125 is applied to an area where the cap 128 and the substrate 102 are adhered, and then an encapsulating process is performed to make the sealant corresponded to the seal line area P3 of the substrate 102, to thereby combine the cap 128 and the substrate 102 provided with the organic EL array 115 having the cathode electrode 112 as shown in FIG. 6G.

In the organic electro-luminescence display device and a fabricating method thereof, the dummy insulating pattern 107 is formed to cover only that portion of the second lines 152 (or signal lines) more densely arranged on the seal line area P3, that is adhering area of both the cap and the substrate. The dummy insulating pattern 107 reduces a stepped difference between the substrate 102 and the second line 152, so that the sealant 125 becomes uniformly formed at the seal line area P3. Hereby, the adhesion of the sealant 125 becomes improved, to thereby improve a packaging of the organic EL array 115.

As described above, in the organic electro-luminescence display device and a fabricating method thereof, the dummy insulating pattern is formed to cover only that portion of the second line (or signal lines) more densely arranged on the seal line area, so that the dummy insulating pattern reduces a stepped difference between the substrate and the second line. Accordingly, the sealant becomes uniformly formed, so that it is possible to improve a packaging of the organic EL array.

## Claims

1. An organic electro-luminescence display device, comprising:
a substrate (102) provided with an organic electro-luminescence array having first (104) and second (112) electrodes crossing each other with having an organic light-emitting layer (110) therebetween;
a cap (128) adhered via a sealant (125) to a seal line area (P3);
a plurality of signal lines (152) connected to any one of the first (104) and the second (112) electrodes and located on the seal line area (P3),
**characterized In that** the plurality of signal lines (152) are arranged, within the seal line area (P3), by a narrower distance as it goes from the seal line area to the organic electro-luminescence array;
a dummy insulating pattern (107) is overlapped with a portion of the seal line area (P3) adjacent to the organic electro-luminescence array, to cover only that portion of the signal lines more densely arranged on the seal line area (P3).

2. The organic electro-luminescence display device according to claim 1, wherein the dummy insulating pattern (107) Is overlapped with the seal line area as much as more than 1/2 of the entire width of the seal line area.

3. The organic electro-luminescence display device according to claim 1, wherein the dummy insulating pattern (107) is formed to cover more than 1/2 of the signal lines.

4. The organic electro-luminescence display device according to claim 1, further comprising an insulating film (106) formed on the first electrode (104) to
define a light-emitting area, wherein the dummy Insulating pattern (107) Is the same material as the insulating film (106).

5. The organic electro-luminescence display according to claim 1, further comprising a plurality of signal lines (152) arranged between the seal line area (P3) and the organic electro-luminescence array.

6. A method of fabricating an organic electro-luminescence display device, comprising:
forming an organic electro-luminescence array having first (104) and second (112) electrodes crossing each other with having an organic light-emitting layer (110) therebetween;
providing a cap (128) adhered via a sealant (125) to a seal line area (P3);
forming a plurality of signal lines (152) connected to any one of the first (104) and the second (112) electrodes and located on the seal line area (P3),
**characterized by**
forming the plurality of signal lines (152) arranged, within the seal line area (P3), by a narrower distance as it goes from the seal line area (P3) to the organic electro-luminescence array;
forming a dummy insulating pattern (107) which is overlapped with a portion of the seal line area (P3) adjacent to the organic electro-luminescence array, to cover only that portion of the signal lines more densely arranged on the seal line area (P3).

7. The method according to claim 6, wherein the organic electro-luminescence array includes an insulating film (106) defining the light-emitting area by partially exposing the first (104) electrode, and the dummy insulating pattern (107) Is simultaneously formed of the same material as the Insulating film (106).

8. The method according to claim 6, further comprising a plurality of signal lines (152) arranged between the seal line area (P3) and the organic electroluminescence array.

## Patentansprüche

1. Organisches Elektrolumineszenz-Anzeigegerät, umfassend:
ein Substrat (102), das mit einer Elektrolumineszenz-Anordnung mit ersten (104) und zweiten (112) Elektroden bereitgestellt ist, die sich kreuzen, mit einer dazwischen angeordneten organischen lichtemittierenden Lage (110);
eine Abdeckung (128), die durch eine Dichtmasse (125) in einen Dichtlinienbereich (P3) geklebt ist;
eine Vielzahl von Signalleitungen (152), die mit einer der ersten (104) und der zweiten (112) Elektroden verbunden ist und sich im Dichtlinienbereich (P3) befindet; **dadurch gekennzeichnet, dass** die Vielzahl von Signalleitungen (152) innerhalb des Dichtlinienbereichs (P3) vom Dichtlinienbereich aus zur organischen Elektrolumineszenz-Anordnung hin in einem schmaler werdenden Abstand angeordnet ist;
wobei ein Isolierattrappenmuster (107) mit einem Teil des Dichtlinienbereichs (P3) in der Nähe der organischen Elektrolumineszenz-Anordnung überlappt ist, um nur den Teil der Signalleitungen zu überdecken, in welchem diese dichter im Dichtlinienbereich (P3) angeordnet sind.

2. Organisches Elektrolumineszenz-Anzeigegerät nach Anspruch 1, wobei das Isolierattrappenmuster (107) den Dichtlinienbereich zu mehr als der Hälfte der Gesamtbreite des Dichtlinienbereichs überlappt.

3. Organisches Elektrolumineszenz-Anzeigegerät nach Anspruch 1, wobei das Isolierattrappenmuster (107) derart gebildet ist, um mehr als die Hälfte der Signalleitungen abzudecken.

4. Organisches Elektrolumineszenz-Anzeigegerät nach Anspruch 1, ferner umfassend einen Isolierungsfilm (106), der an der ersten Elektrode (104) gebildet ist, um einen lichtemittierenden Bereich zu definieren, wobei das Isolierattrappenmuster (107) aus demselben Material besteht, wie der Isolierungsfilm (106).

5. Organisches Elektrolumineszenz-Anzeigegerät nach Anspruch 1, ferner umfassend eine Vielzahl von Signalleitungen (152), die zwischen dem Dichtlinienbereich (P3) und der organischen Elektrolumineszenz-Anordnung angeordnet ist.

6. Verfahren zur Herstellung eines organischen Elektroluminszenz-Anzeigegeräts, umfassend:
das Bilden einer organischen Elektrolumineszenz-Anordnung mit ersten (104) und zweiten (112) Elektroden, die sich kreuzen und eine dazwischen angeordnete organische lichtemittierende Lage (110) aufweisen;
das Bereitstellen einer Abdeckung (128), die durch eine Dichtmasse (125) in einen Dichtlinienbereich (P3) geklebt ist;
das Bilden einer Vielzahl von Signalleitungen (152), die mit einer der ersten (104) und der zweiten (112) Elektroden verbunden ist und sich im Dichtlinienbereich (P3) befindet;
**gekennzeichnet durch**
das Bilden einer Vielzahl von Signalleitungen (152) derart, dass diese vom Dichtlinienbereich (P3) aus zur organischen Elektrolumineszenz-Anordnung hin in einem schmaler werdenden Abstand angeordnet ist;
das Bilden eines Isolierattrappenmusters (107), das mit einem Teil des Dichtlinienbereichs (P3) in der Nähe der organischen Elektrolumineszenz-Anordnung überlappt ist, um nur den Teil der Signalleitungen zu überdecken, in welchem diese dichter im Dichtlinienbereich (P3) angeordnet sind.

7. Verfahren nach Anspruch 6, wobei die organische Elektrolumineszenz-Anordnung einen Isolierungsfilm (106) enthält, der den lichtemittierenden Bereich durch teilweises Freilegen der ersten (104) Elektrode definiert und wobei das Isolierattrappenmuster (107) gleichzeitig aus demselben Material gebildet ist, wie der Isolierungsfilm (106).

8. Verfahren nach Anspruch 6, ferner umfassend eine Vielzahl von Signalleitungen (152), die zwischen dem Dichtlinienbereich (P3) und der organischen Elektrolumineszenz-Anordnung angeordnet sind.

## Revendications

1. Dispositif d'affichage à électroluminescence organique, comprenant :
un substrat (102) pourvu d'une puce à électroluminescence organique ayant des première (104) et deuxième (112) électrodes se coupant mutuellement ayant une couche électroluminescente organique (110) entre celles-ci ;
un capuchon (128) collé à l'aide d'un agent de scellement (125) à une zone de ligne de scellement (P3) ;
une pluralité de lignes de signal (152) connectées à l'une quelconque des première (104) et deuxième (112) électrodes et situées sur la zone de ligne de scellement (P3),
**caractérisé en ce que** la pluralité de lignes de signal (152) sont agencées, dans la zone de ligne de scellement (P3), par une distance plus étroite au fur et à mesure qu'elle va de la zone de ligne de scellement à la puce à électroluminescence organique ;
un schéma d'isolation fictif (107) se chevauche avec une partie de la zone de ligne de scellement (P3) adjacente à la puce à électroluminescence organique, pour couvrir uniquement la partie des lignes de signal agencées de façon plus dense sur la zone de ligne de scellement (P3).

2. Dispositif d'affichage à électroluminescence organique selon la revendication 1, dans lequel le schéma d'isolation fictif (107) se chevauche avec la zone de ligne de scellement sur jusqu'à plus de 1/2 de la largeur totale de la zone de ligne de scellement.

3. Dispositif d'affichage à électroluminescence organique selon la revendication 1, dans lequel le schéma d'isolation fictif (107) est formé de manière à couvrir plus de 1/2 des lignes de signal.

4. Dispositif d'affichage à électroluminescence organique selon la revendication 1, comprenant en outre un film isolant (106) formé sur la première électrode (104) pour définir une zone électroluminescente, où le motif d'isolation fictif (107) est le même matériau que le film isolant (106).

5. Affichage à électroluminescence organique selon la revendication 1, comprenant en outre une pluralité de lignes de signal (152) agencées entre la zone de ligne de scellement (P3) et la puce à électroluminescence organique.

6. Procédé de fabrication d'un dispositif d'affichage à électroluminescence organique, comprenant :
la formation d'une puce à électroluminescence organique ayant des première (104) et deuxième (112) électrodes se coupant mutuellement ayant une couche électroluminescente organique (110) entre celles-ci ;
la fourniture d'un capuchon (128) collé à l'aide d'un agent de scellement (125) à une zone de ligne de scellement (P3) ;
la formation d'une pluralité de lignes de signal (152) connectées à l'une quelconque des première (104) et deuxième (112) électrodes et situées sur la zone de ligne de scellement (P3),
**caractérisé par**
la formation de la pluralité de lignes de signal (152) agencées, dans la zone de ligne de scellement (P3), par une distance plus étroite au fur et à mesure qu'elle va de la zone de ligne de scellement à la puce à électroluminescence organique ;
la formation d'un schéma d'isolation fictif (107) qui se chevauche avec une partie de la zone de ligne de scellement (P3) adjacente à la puce à électroluminescence organique, pour couvrir uniquement la partie des lignes de signal agencées de façon plus dense sur la zone de ligne de scellement (P3).

7. Procédé selon la revendication 6, dans lequel la puce à électroluminescence organique comprend un film isolant (106) définissant la zone électroluminescente en exposant partiellement la première (104) électrode, et le schéma d'isolation fictif (107) est simultanément formé du même matériau en tant que film isolant (106).

8. Procédé selon la revendication 6, comprenant en outre une pluralité de lignes de signal (152) agencées entre la zone de ligne de scellement (P3) et la puce à électroluminescence organique.
